# EUROPÄISCHE PATENTSCHRIFT

(11) **EP 1 563 542 B1**
(45) Veröffentlichungstag und Bekanntmachung des Hinweises auf die Patenterteilung: **23.12.2009**
(21) Anmeldenummer: 03779692.7
(22) Anmeldetag: 12.11.2003
(51) Int. Cl.: H01L 27/02, H01L 27/102, H01L 29/10, H01L 21/8242, H01L 27/108

(54) **FELDEFFEKTTRANSISTORSTRUKTUR, ZUGEHÖRIGE HALBLEITER-SPEICHERZELLE SOWIE ZUGEHÖRIGES HERSTELLUNGSVERFAHREN**
FIELD EFFECT TRANSISTOR STRUCTURE, ASSOCIATED SEMICONDUCTOR STORAGE CELL, AND CORRESPONDING PRODUCTION METHOD
STRUCTURE DE TRANSISTOR A EFFET DE CHAMP, CELLULE DE MEMOIRE A SEMI-CONDUCTEURS ASSOCIEE ET PROCEDE DE PRODUCTION ASSOCIE

(30) Priorität: 21.11.2002 DE 10254415
(43) Veröffentlichungstag der Anmeldung: 17.08.2005
(73) Patentinhaber: Infineon Technologies AG, 81669 München (DE)
(72) Erfinder: HIERLEMANN, Matthias, 300 Hsinchu (TW); STRASSER, Rudolf, Wappingers Falls, NY 12590 (US)
(74) Vertreter: Kindermann, Peter
(86) Internationale Anmeldenummer: PCT/DE2003/003748
(87) Internationale Veröffentlichungsnummer: WO 2004/047182

(56) Entgegenhaltungen:
- US-A- 5 366 908
- US-A- 6 046 480
- US-A1- 2001 003 369
- US-B1- 6 191 455

## Beschreibung

Die vorliegende Erfindung bezieht sich auf eine Feldeffekttransistorstruktur, eine zugehörige Halbleiter-Speicherzelle sowie ein zugehöriges Herstellungsverfahren und insbesondere auf eine Feldeffekttransistorstruktur, wie sie in DRAM-Speichern eingesetzt werden kann.

In der Halbleitertechnik werden insbesondere zur Herstellung von sogenannten DRAM-Speichern (Dynamic Random Access Memory) die fortschrittlichsten Technologien mit den höchsten Integrationsdichten verwendet. Mit zunehmender Packungsdichte bzw. Integrationsdichte ergeben sich jedoch beispielsweise in DRAM-Halbleiterspeichern folgende Schwierigkeiten:

Um ein Kurzkanalverhalten (Roll-Off) eines Auswahltransistors in einer DRAM-Halbleiter-Speicherzelle zu kontrollieren, ist von Technologie-Generation zu Technologie-Generation eine Erhöhung einer zugehörigen Wannendotierung bzw. eines Kanalimplants notwendig. Daraus ergibt sich jedoch ein stärkerer sogenannter Body-Effekt, welcher wiederum eine Verschlechterung eines Schreibverhaltens zur Folge hat. Der sogenannte Body-Effekt äußert sich in einer Erhöhung der Schwellwertspannung des Feldeffekttransistors mit zunehmender Source-Body-Spannung. Unter dem Begriff "Body" wird nachfolgend insbesondere das unmittelbar in der Nähe des Transistors bzw. der Source-/Draingebiete und des Kanalgebiets befindliche Halbleitersubstrat bezeichnet.

Während eines Schreibvorgangs in einer DRAM-Speicherzelle mit Grabenkondensator (zum Beispiel Schreiben einer logischen "1") erhöht sich das Potenzial eines Source-/Draingebiets, welches beispielsweise am Grabenkondensator angeschlossen ist, mit zunehmender Aufladung der entsprechenden Grabenkondensator-Kapazität. Bei festem Body-Potenzial bedeutet dies eine Erhöhung der Spannung zwischen diesem Source-/Draingebiet und dem Body, wodurch der Transistor abhängig von einem Ladezustand des Grabenkondensators seine Schwellwertspannung auf Grund des Body-Effekts erhöht. Dieses Phänomen wird allgemein als "Source-Follower-Mode" bezeichnet.

Als direkte Folge der erhöhten Schwellwertspannung liefert der Feldeffekttransistor nun auch einen geringeren Strom bei ansonsten identischer Spannungsdifferenz zwischen einem weiteren Source-/Draingebiet bzw. einer Bit-Leitung und der Kapazität des Grabenkondensators. Somit dauert die vollständige Aufladung des Grabenkondensators entsprechend länger, weshalb dieser Body-Effekt die Schreibperformance beispielsweise in einer DRAM-Speicherzelle entsprechend begrenzt.

Darüber hinaus wird es mit der zunehmenden Integrationsdichte immer schwieriger, eine Kontaktierung der lokalen, d.h. auf den Auswahltransistor bezogenen Wannengebiete sicherzustellen. Insbesondere auf Grund von Verarmungsphänomenen um die Grabenkondensatorgebiete herum, fällt es insbesondere bei hoher Packungsdichte schwer, einen niederohmigen bzw. hochleitenden Strompfad von den Wannenkontakten zu den Auswahltransistoren ohne Potenzialbarrieren zu gewährleisten. Dies gilt insbesondere, da die Wannendotierung auf Grund der damit verbundenen Erhöhung Feldstärken an Anschlussgebieten zum Grabenkondensator nicht beliebig erhöht werden kann.

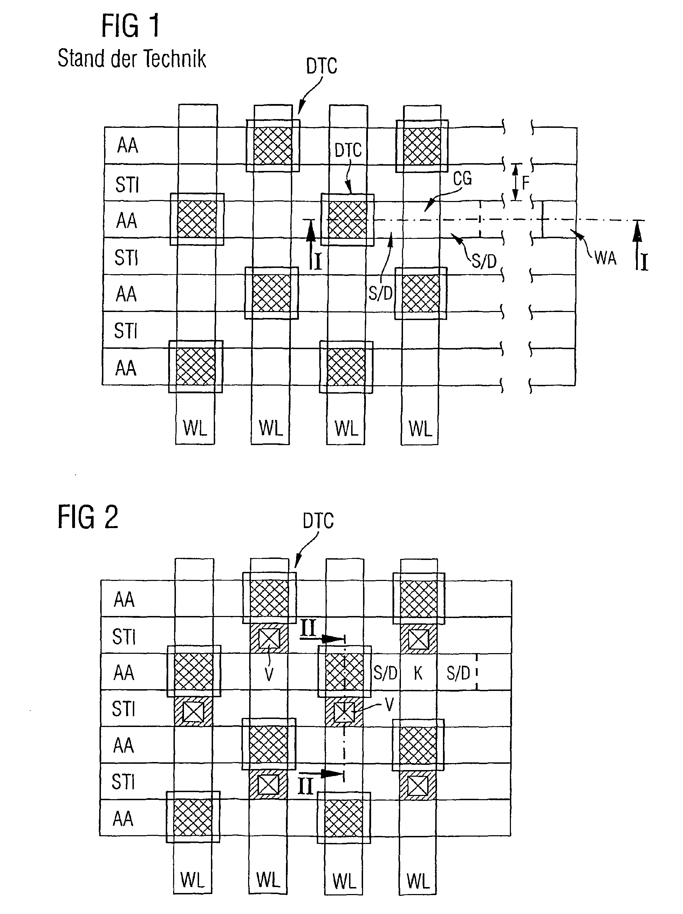

Die Figur 1 zeigt eine vereinfachte Draufsicht einer herkömmlichen DRAM-Speicherzellenanordnung, wobei mit STI streifenförmig ausgebildete flache Grabenisolierungen bezeichnet sind, die eine Vielzahl von streifenförmigen aktiven Gebieten AA in einem Halbleitersubstrat ausbilden. In den aktiven Gebieten AA sind jeweilige erste und zweite Source-/Draingebiete S/D mit einem dazwischen liegenden Kanalgebiet zur Erzeugung einer Feldeffekttransistorstruktur ausgebildet. Zur Realisierung einer Steuerschicht CG oberhalb des Kanalgebiets sind im Wesentlichen senkrecht zu den streifenförmigen aktiven Gebieten AA streifenförmige Wortleitungen WL ausgebildet, die eine Ansteuerung der Feldeffekttransistorstruktur ermöglichen. Mit DTC ist ein Grabenkondensator (Deep Trench Capacitor) angedeutet, der mit einem der Source-/Draingebiete leitend in Verbindung steht, wobei das weitere Source-/Draingebiet S/D an eine nicht dargestellte Bitleitung angeschaltet wird. Ferner ist mit F in Figur 1 eine minimale lithografisch herstellbare Strukturbreite dargestellt.

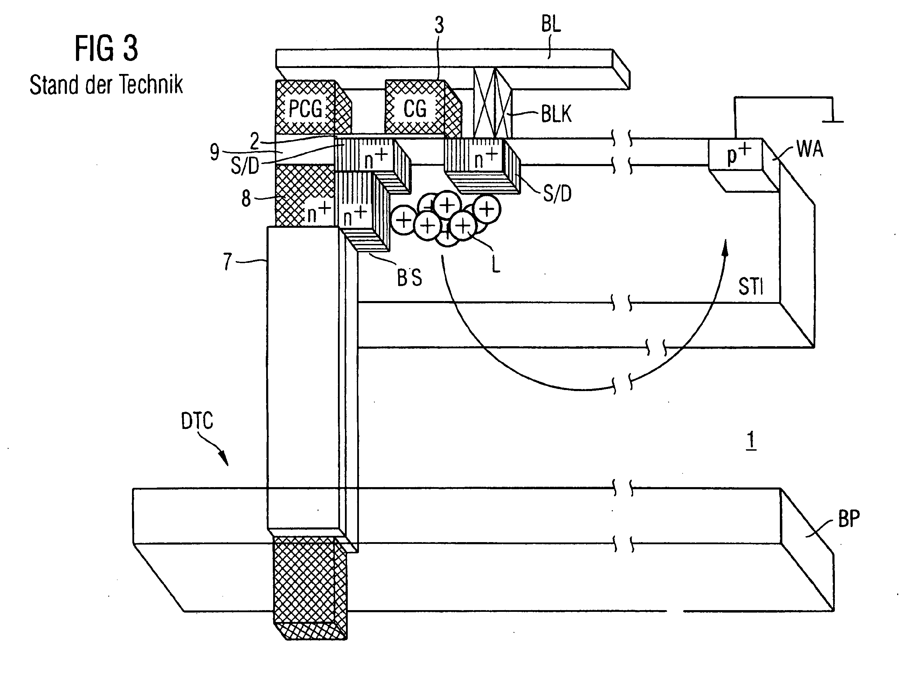

Figur 3 zeigt eine vereinfachte perspektivische Ansicht der Speicherzellenanordnung gemäß Figur 1 entlang eines Schnitts I-I, wobei gleiche Bezugszeichen gleiche oder entsprechende Elemente bzw. Schichten bezeichnen und auf eine wiederholte Beschreibung nachfolgend verzichtet wird.

Gemäß Figur 3 besteht eine Halbleiter-Speicherzelle demzufolge aus einem Grabenkondensator DTC (Deep Trench Capacitor), der über eine elektrisch leitende vergrabene Anschlussplatte BP (Buried Plate) mit weiteren Grabenkondensatoren bzw. deren nicht dargestellten Außenelektroden im Speicherfeld verbunden ist. Der untere Teil des Grabenkondensators DTC mit seinen inneren und äußeren Elektroden ist in Figur 3 nicht dargestellt.

Der in Figur 3 dargestellte obere Bereich des Grabenkondensators DTC weist eine Grabenkondensator-Anschlussschicht 8 auf, die beispielsweise polykristallines hochdotiertes Halbleitermaterial und insbesondere Polysilizium aufweist. Zur Isolierung dieser Grabenkondensator-Anschlussschicht 8 besitzt der obere Teil des Grabenkondensators DTC eine Kragenisolationsschicht 7 (Collar), die beispielsweise Siliziumdioxid aufweist. Zum Verbinden der Grabenkondensator-Anschlussschicht 8 mit einem ersten Source-/Draingebiet S/D ist beispielsweise eine vergrabene Schicht BS (Buried Strap) unterhalb des ersten Source-/Draingebiets S/D ausgebildet. Diese vergrabene Schicht BS stellt wie das erste Source-/Draingebiet S/D vorzugsweise ein hochdotiertes Halbleitergebiet von einem ersten Leitungstyp n dar, welches im Halbleitersubstrat vom zum ersten Leitungstyp n entgegengesetzten zweiten Leitungstyp p ausgebildet ist. Zur Isolierung der Grabenkondensator-Anschlussschicht 8 von einer an der Substratoberfläche ausgebildeten Wortleitung WL bzw. deren passiven Steuerschichtbereich PCG (Passive Control Gate) ist eine Top-Isolierschicht 9 ausgebildet, die vorzugsweise aus Siliziumdioxid besteht.

Ferner ist an der Oberfläche des Halbleitersubstrats ein zweites Source-/Draingebiet wiederum vom ersten Leitungstyp n im Halbleitersubstrat 1 ausgebildet, wodurch ein Kanalgebiet der Feldeffekttransistorstruktur festgelegt wird. An der Oberfläche des Kanalgebiets bzw. des Halbleitersubstrats 1 ist zumindest zwischen diesen ersten und zweiten Source-/Draingebieten S/D eine Gate-Isolationsschicht 2 ausgebildet, an deren Oberfläche eine Steuerschicht 3 (CG, Control Gate) als Teil der streifenförmig ausgebildeten Wortleitung WL die Ansteuerung der Feldeffekttransistorstruktur übernimmt. Über einen Bitleitungskontakt BLK, der das zweite Source-/Draingebiet S/D der Feldeffekttransistorstruktur kontaktiert, wird dieses Gebiet an eine Bitleitung BL angeschlossen, die im Wesentlichen oberhalb der Wortleitungen WL und parallel zu den streifenförmig ausgebildeten aktiven Gebieten AA liegt.

Zum Anschließen eines nicht explizit dargestellten Wannengebiets im Halbleitersubstrat 1 ist üblicherweise ein Wannenanschluss-Dotiergebiet WA in einiger Entfernung von der Feldeffekttransistorstruktur vorgesehen. Dieses Wannenanschluss-Dotiergebiet WA besitzt gemäß Figur 3 einen zum ersten Leitungstyp n entgegengesetzten zweiten Leitungstyp p und dient üblicherweise dazu, die im Body bzw. unmittelbar an der Feldeffekttransistorstruktur anliegenden Halbleitersubstrat 1 auftretenden Ladungsträger L abzuführen bzw. auszuräumen.

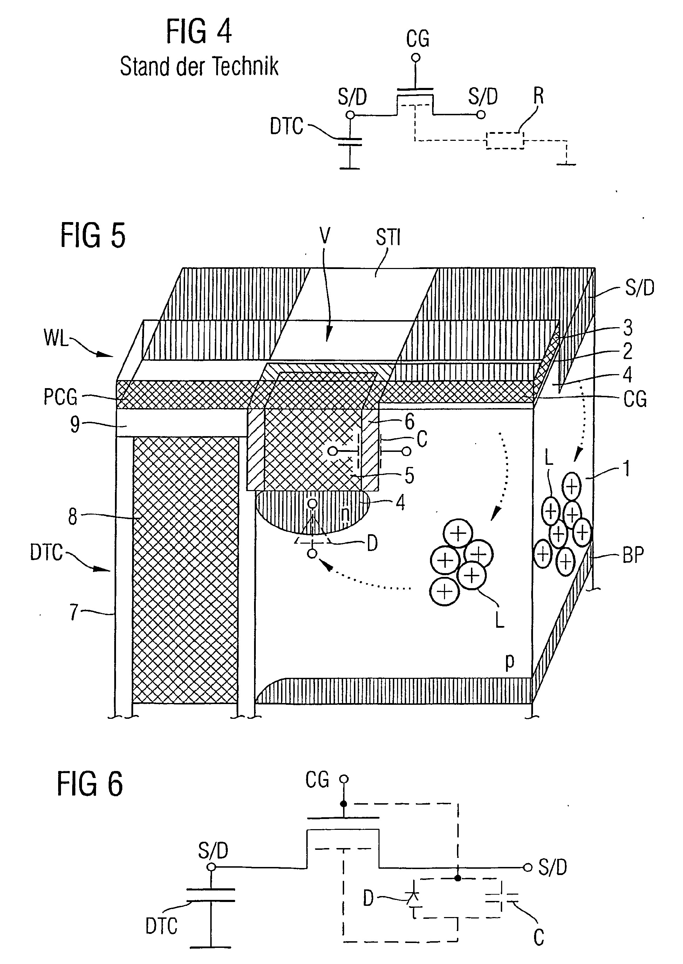

Figur 4 zeigt ein vereinfachtes Ersatzschaltbild der Halbleiter-Speicherzelle gemäß Figur 3, wobei gleiche Bezugszeichen gleiche oder entsprechende Elemente bzw. Gebiete bezeichnen und auf eine wiederholte Beschreibung nachfolgend verzichtet wird.

Insbesondere der Widerstand R, der sich im Wesentlichen aus einer elektrischen Leitfähigkeit des Wannengebiets bzw. des Halbleitersubstrats 1 zum Wannenanschluss-Dotiergebiet WA ergibt, erhöht sich mit zunehmender Integrationsdichte, was aufgrund des vorstehend beschriebene Body-Effekts zu einer Beeinträchtigung der Funktion führt.

Insbesondere bei DRAM-Halbleiter-Speicherzellen mit zugehörigen Grabenkondensatoren verschärft sich dieses Problem dadurch, dass die in einem Feld gemäß Figur 1 angeordneten Grabenkondensatoren DTC immer weiter zusammenrücken und somit der für das Abführen der Ladungsträger L notwendige Freiraum zwischen den Grabenkondensatoren immer mehr eingeengt wird. Weiterhin besteht bei DRAM-Halbleiter-Speicherzellen auch nicht die Möglichkeit des Abführens der Ladungsträger L über die tieferen Regionen des Halbleitersubstrats 1, da durch die vergrabene Anschlussplatte BP zum Verbinden der Gegenelektroden der Grabenkondensatoren DTC in diesem Bereich eine Isolierschicht aufgebaut wird.

Ein ungenügender bzw. hochohmiger Wannenanschluss des Bodys bzw. des Halbleitersubstrats in unmittelbarer Nähe der Feldeffekttransistorstruktur führt jedoch über kurz oder lang zu dessen Aufladung und in der Folge auf Grund des Body-Effekts zu einer Verringerung der effektiven Schwellwertspannung und somit zu erhöhten Leckströmen. Insbesondere bei der in Figur 3 dargestellten DRAM-Halbleiter-Speicherzelle kommt es somit zu einer Verschlechterung der Retention Time bzw. Ladungshaltezeit.

Aus der Druckschrift US-B1-6 191 455 ist eine Feldeffekttransistorstruktur bekannt mit einem ersten und zweiten Source-/Draingebiet, die in einem Halbleitersubstrat zum Festlegen eines Kanalgebiets ausgebildet sind, wobei eine Gate-Isolationsschicht an der Oberfläche des Kanalgebiets und eine Steuerschicht an der Oberfläche der Gate-Isolationsschicht ausgebildet sind. Zur Realisierung einer Überspannungsschutzdiode ist ferner ein Dioden-Dotiergebiet im Halbleitersubstrat ausgebildet, wobei eine elektrisch leitende Dioden-Anschlussschicht das Dioden-Dotiergebiet an die Steuerschicht anschließt.

Aus der Druckschrift US 2001/003369 A1 ist eine weitere Feldeffekttransistorstruktur bekannt, die ein durch ionisierende Teilchen, wie z.B. schweren Ionen, Protonen, Alpha-Teilchen usw., verursachtes unerwünschtes Schalten zuverlässig verhindert. Hierbei wird eine mittels Dotierung ausgebildete vergrabene Schicht unter das gesamte Draingebiet sowie unter Teilbereiche des Kanalgebiets gelegt und über eine Diode mit dem Gate des Feldeffekttransistors verbunden. Dadurch können die durch eintreffende Teilchen entstehenden Ladungsträger kompensiert werden.

In ähnlicher Weise beziehen sich auch die Druckschriften US-A-6 046 480 und US-A-5 366 908 auf Feldeffekttransistorstrukturen, wobei eine im Halbleitersubstrat ausgebildete Überspannungsschutzdiode mit dem Gate bzw. der Steuerschicht des Feldeffektransistors verbunden ist. Überspannungen, wie sie insbesondere durch elektrostatische Aufladung entstehen können, werden somit zuverlässig kompensiert und eine Zerstörung insbesondere der empfindlichen Gateschicht verhindert.

Der Erfindung liegt die Aufgabe zu Grunde, eine Feldeffekttransistorstruktur, eine zugehörige Halbleiter-Speicherzelle sowie ein zugehöriges Herstellungsverfahren zu schaffen, bei dem die elektrischen Eigenschaften auch bei hohen Integrationsdichten im Wesentlichen unbeeinflusst bleiben.

Erfindungsgemäß wird diese Aufgabe hinsichtlich der Feldeffekttransistorstruktur durch die Merkmale des Patentanspruchs 1, hinsichtlich der Halbleiter-Speicherzelle durch die Merkmale des Patentanspruchs 5 und hinsichtlich des Herstellungsverfahrens durch die Maßnahmen des Patentanspruchs 11 gelöst.

Insbesondere durch das Ausbilden einer dielektrischen Schicht an den Wänden der Vertiefung zwischen der Dioden-Anschlussschicht und dem Halbleitersubstrat zum Realisieren eines mit der Steuerschicht verbundenen Kondensators, wird neben der Limitierung des Body-Potenzials durch die Diode auch eine verstärkte dynamische Ankopplung der Steuerschicht an den Body bzw. das Halbleitersubstrat ermöglicht. Bei oft wechselnden Signalen an der Steuerschicht erhält man dadurch ein besonders schnelles und effektives Abführen von Ladungsträgern, wodurch die elektrischen Eigenschaften in besonderem Maße unbeeinflusst bleiben.

Die Vertiefung V ist beispielsweise unmittelbar neben einem Kanalgebiet in einer flachen Grabenisolierung ausgebildet, wodurch man eine besonders platzoptimierte Realisierung erhält, die für hohe Integrationsdichten besonders geeignet ist.

Insbesondere bei Verwendung von hochdotiertem Halbleitermaterial als Dioden-Anschlussschicht kann auf Grund einer Ausdiffusion bei späteren thermischen Prozessschritten das Dioden-Dotiergebiet ohne zusätzlichen Prozessschritt und selbstjustierend im Halbleitersubstrat ausgebildet werden, wodurch die Anforderungen an eine Justiergenauigkeit wesentlich vereinfacht werden.

Eine Halbleiter-Speicherzelle mit einem Auswahltransistor der vorstehend beschriebenen Art ist vorzugsweise mit ihrem ersten Source-/Draingebiet an einen Grabenkondensator und mit ihrem zweiten Source-/Draingebiet an eine Bitleitung angeschlossen, wobei die Steuerschicht einen Teil einer Wortleitung darstellt, die senkrecht zur Bitleitung verläuft, und das Dioden-Dotiergebiet unterhalb der Wortleitung im Halbleitersubstrat ausgebildet ist. Bei einer derartigen Anordnung erhält man auf besonders einfache Art und Weise eine selbstjustierende Kontaktierung zwischen der Steuerschicht und dem Dioden-Dotiergebiet.

Ferner kann eine Grabenisolierung streifenförmig im Halbleitersubstrat zum Ausbilden von streifenförmigen aktiven Gebieten ausgebildet sein, wobei der Grabenkondensator im Wesentlichen im aktiven Gebiet liegt. Auf diese Weise kann die Grabenisolierung auch als isolierende dielektrische Schicht für die Dioden-Anschlussschicht verwendet werden, wodurch sich eine besonders flächenoptimierte Realisierung einer Halbleiter-Speicherzellenanordnung ergibt.

Insbesondere für Grabenkondensatoren, die an der Oberfläche eine Breite aufweisen, die größer ist als eine Breite des aktiven Gebietes kann zum Freilegen einer an das aktive Gebiet angrenzenden Grabenisolierung der Grabenkondensator in eine weitere angrenzende Grabenisolierung verschoben werden, wodurch die Vertiefung wiederum optimal in die Grabenisolierung eingepasst werden kann und sich eine optimale Layout-Realisierung auch für diese Grabenkondensator-Typen ergibt.

Vorzugsweise kann ein Oberflächenquerschnitt des Grabenkondensators eine ovale Form aufweisen, wodurch sich unter Ausnutzung von krümmungsabhängigen Materialeigenschaften eine selbstjustierende Anschlussmöglichkeit der Feldeffekttransistorstruktur an den Grabenkondensator ergibt.

Hinsichtlich des Verfahrens zur Herstellung einer Halbleiterstruktur wird vorzugsweise ein Halbleitersubstrat in geeigneter Weise vorbereitet, eine Vertiefung in einer Grabenisolierung ausgebildet, die bis zum Halbleitersubstrat reicht und eine dielektrische Schicht für einen Kondensator an den Wänden der Vertiefung aufweist, ein Dioden-Dotiergebiet am Boden der Vertiefung ausgebildet und eine elektrisch leitende Dioden-Anschlussschicht in der Vertiefung aufgefüllt, eine Maskenschicht entfernt, eine Gate-Isolationsschicht ausgebildet, eine Steuerschicht an der Oberfläche der Gate-Isolationsschicht ausgebildet, die so hergestellte Oberfläche zumindest bis zur Grabenisolierung planarisiert und anschließend eine elektrisch leitende Verbindungsschicht zum Verbinden der Steuerschicht mit der Dioden-Anschlussschicht und dem Kondensator ausgebildet. Auf diese Weise können Standardprozesse mit minimalen Änderungen oder Einschüben von Zusatzprozessschritten zur Realisierung der vorstehend beschriebenen Dioden-Dotiergebiete und Dioden-Anschlussschichten angepasst werden. Es ergibt sich daraus eine besonders einfache und kostengünstige Realisierung.

In den weiteren Ansprüchen sind weitere vorteilhafte Ausgestaltungen der Erfindung gekennzeichnet.

Die Erfindung wird nachstehend anhand von Ausführungsbeispielen und Bezugnahme auf die Zeichnung näher beschrieben.

Es zeigen:
Figur 1 eine vereinfachte Draufsicht einer Halbleiter-Speicherzellenanordnung gemäß dem Stand der Technik;
Figur 2 eine vereinfachte Draufsicht einer Halbleiter-Speicherzellenanordnung gemäß einem ersten Ausführungsbeispiel;
Figur 3 eine vereinfachte perspektivische Ansicht einer herkömmlichen Halbleiter-Speicherzelle gemäß Figur 1 entlang eines Schnitts I-I;
Figur 4 ein vereinfachtes Ersatzschaltbild der herkömmlichen Halbleiter-Speicherzelle gemäß Figur 3;
Figur 5 eine vereinfachte perspektivische Ansicht einer Halbleiter-Speicherzelle gemäß Figur 2 entlang eines Schnitts II-II;
Figur 6 ein vereinfachtes Ersatzschaltbild der erfindungsgemäßen Halbleiter-Speicherzelle gemäß Figur 5;
Figur 7 eine vereinfachte Draufsicht einer weiteren Halbleiter-Speicherzellenanordnung gemäß dem Stand der Technik;
Figur 8 eine vereinfachte Draufsicht einer Halbleiter-Speicherzellenanordnung gemäß einem zweiten Ausführungsbeispiel; und
Figur 9A bis 9F vereinfachte Schnittansichten entlang eines Schnitts III-III gemäß Figur 8 zur Veranschaulichung wesentlicher Herstellungsschritte in einem Herstellungsverfahren gemäß dem zweiten Ausführungsbeispiel.

Figur 2 zeigt eine vereinfachte Draufsicht einer Halbleiter-Speicherzellenanordnung gemäß einem ersten Ausführungsbeispiel, wobei gleiche Bezugszeichen gleiche oder entsprechende Element bzw. Schichten darstellen wie in Figur 1 und auf eine wiederholte Beschreibung nachfolgend verzichtet wird.

Die in Figur 3 dargestellte perspektivische Ansicht entlang eines Schnitts I-I in Figur 1 entspricht hierbei im wesentlichen auch einem entsprechenden nicht dargestellten Schnitt in Figur 2, wobei jedoch das Wannenanschluss-Dotiergebiet WA im erfindungsgemäßen Ausführungsbeispiel nicht länger notwendig ist.

Gemäß Figur 2 wird nunmehr dieses üblicherweise notwendige, jedoch auf Grund von erhöhten Packungsdichten nicht länger wirkungsvolle Wannenanschluss-Dotiergebiet durch eine in einer flachen Grabenisolierung STI (Shallow Trench Isolation) ausgebildete Vertiefung V ersetzt, an deren Bodenbereich ein Dioden-Dotiergebiet im Halbleitersubstrat ausgebildet wird.

Die Figur 5 zeigt eine vereinfachte perspektivische Ansicht der erfindungsgemäßen Halbleiter-Speicherzelle gemäß Figur 2 entlang eines Schnitts II-II, wobei wiederum gleiche Bezugszeichen gleiche oder entsprechende Elemente bzw. Schichten bezeichnen und nachfolgend auf eine wiederholte Beschreibung verzichtet wird.

Gemäß Figuren 2 und 5 weist die erfindungsgemäße Feldeffekttransistorstruktur ein erstes und zweites Source-/Draingebiet S/D von einem ersten Leitungstyp n auf, die in einem Halbleitersubstrat 1 von einem zum ersten Leitungstyp n entgegengesetzten zweiten Leitungstyp p zum Festlegen eines Kanalgebiets K ausgebildet sind. Als Halbleitermaterial 1 wird vorzugsweise kristallines Silizium verwendet, wobei auch alternative Halbleitermaterialien wie Germanium, III-V-Halbleitermaterialien und dergleichen verwendet werden können.

An der Oberfläche des Kanalgebiets K ist eine Gate-Isolationsschicht 2 ausgebildet, die vorzugsweise thermisch ausgebildetes Siliziumdioxid aufweist, jedoch auch aus einem anderen elektrisch isolierenden Material bestehen kann. Insbesondere können hierbei auch Tunneloxide oder anderweitige Gate-Dielektrika verwendet werden.

An der Oberfläche der Gate-Isolationsschicht 2 ist ferner eine Steuerschicht 3 ausgebildet, die einen Steuerschichtbereich CG (Control Gate) einer zugehörigen Wortleitung WL darstellt.

Zum Realisieren einer Diode D ist erfindungsgemäß ein Dioden-Dotiergebiet 4 im Halbleitersubstrat 1 bzw. im Body der Feldeffekttransistorstruktur ausgebildet, wobei eine Dioden-Anschlussschicht 5 bzw. ein entsprechender Teilbereich der Wortleitung WL die Steuerschicht 3 elektrisch leitend mit dem Dioden-Dotiergebiet 4 zum Abführen von überschüssigen Ladungsträgern L (z.B. Löchern) verbindet.

Auf diese Weise kann die überschüssige Ladung L im Halbleitersubstrat 1 bzw. im Body der Feldeffekttransistorstruktur mit dem Potential der Steuerschicht 3 ausgeglichen werden (pn-Übergang, pn-Kapazität).

Vorzugsweise ist das Dioden-Dotiergebiet 4 in einem Bodenbereich einer Vertiefung V im Halbleitersubstrat 1 ausgebildet, wodurch die Diode D in einer besonders geeigneten Tiefe innerhalb des Halbleitersubstrats 1 positioniert werden kann.

Gemäß Figur 5 wird diese Vertiefung V innerhalb der als flacher Grabenisolierung ausgebildeten Grabenisolierung STI unmittelbar unterhalb der Wortleitung WL bis zum Halbleitersubstrat 1 ausgebildet, wodurch das Dioden-Dotiergebiet 4 in einer optimalen Tiefe, nämlich der Tiefe der Grabenisolierung STI innerhalb des Halbleitersubstrats ausgebildet wird. Darüber hinaus kann ein Teil der Grabenisolierung STI an den Wänden der Vertiefung V bestehen bleiben, wodurch eine dielektrische Schicht 6 zwischen der Dioden-Anschlussschicht 5 und dem Halbleitersubstrat 1 zum Realisieren eines mit der Steuerschicht 3 verbundenen zusätzlichen Kondensators C ausgebildet wird. Durch diesen zusätzlichen Kondensator C erhält man eine stark dynamische Ankopplung der Wortleitung bzw. der Steuerschicht 3 an den Body bzw. das Halbleitersubstrat 1, wodurch die herkömmliche Fixierung des Potenzials durch den üblicherweise vorhandenen Wannenanschluss-Dotiergebiet bzw. Wannenkontakt WA nicht mehr besteht. Insbesondere bei einem Schreibvorgang folgt demzufolge das Potenzial des Bodys dem Potenzial der Wortleitung WL, wodurch sich eine Potenzialdifferenz zwischen der Wortleitung WL und dem Body verringert und sich verkürzte Schreibzeiten (vergleichbar mit Dynamic-VT-Konzepten in Logiktechnologien) ergeben.

Andererseits wird durch den Dioden-Kontakt bzw. pn-Übergang der Wortleitung WL mit dem Halbleitersubstrat 1 eine Limitierung des Bodypotenzials nach oben durchgeführt. Genauer gesagt werden in dem Moment, in dem das Body-Potenzial ein "LOW"-Potenzial der Wortleitung WL um ca. 0,5 V übersteigen würde, Elektronen in den Body injiziert, welche letztendlich den in Figur 5 dargestellten Ladungsträger- bzw. Löcherüberschuss L im Body durch Rekombination beseitigen. Damit kann sich ein Gleichgewicht einstellen, wobei kein derartiger Ausgleichsvorgang stattfindet, wenn die Halbleiter-Speicherzelle nicht ausgewählt ist. Das heißt, für negative Wortleitungspotenziale von beispielsweise -0,5 V ergibt sich außerhalb des Schreibvorgangs ein Body-Potenzial von ca. 0 V.

Auf diese Weise kann ein sogenannter Source-Follower-Effekt verhindert werden, wodurch sich beispielsweise eine Schreibperformance verbessert. Ferner wird insbesondere durch den zusätzlichen Kondensator C ein sogenannter "Gate-Overdrive" verringert, wodurch man eine zusätzliche Flexibilität bei der Schaltungsentwicklung erhält. Die Anforderungen hinsichtlich der Steuerschichtpotenziale bzw. Potenziale auf der Wortleitung, einer Zuverlässigkeit der Gate-Isolationsschicht gegenüber GIDL-Phänomenen (Gate Induced Drain Leakage) usw. können dadurch entschärft werden. Insbesondere erhält man dadurch aber eine weiter verbesserte Integrationsdichte auf Grund der integrierten Body-Kontaktierung, da nunmehr die platzintensiven herkömmlichen Wannenkontakte entfallen können.

Insgesamt verbessern sich demzufolge die elektrischen Eigenschaften der Feldeffekttransistorstruktur wesentlich bzw. können die elektrischen Eigenschaften auch für zukünftige Integrationsdichten beibehalten werden.

Gemäß Figur 5 ist zur Realisierung einer DRAM-Halbleiter-Speicherzelle ferner ein oberer Bereich eines Grabenkondensators DTC mit seiner Grabenkondensator-Anschlussschicht 8 und seiner Isolations-Grabenschicht 7 dargestellt, die im Wesentlichen gemäß dem Stand der Technik nach Figur 3 ausgebildet sind. An der Oberfläche dieses Grabenkondensators DTC ist demzufolge eine Top-Isolierschicht 9 ausgebildet, wodurch der darüber liegende Bereich der Wortleitung WL als passive Steuerschicht PCG (Passive Control Gate) wirkt.

Zum Verbinden einer nicht dargestellten Außen- bzw. Gegenelektrode der Grabenkondensatoren DTC ist wiederum in einem tieferen Bereich des Halbleitersubstrats 1 eine vergrabene Anschlussplatte BP (Buried Plate) vorgesehen, die üblicherweise aus einem Halbleitermaterial vom ersten Leitungstyp n besteht und somit eine isolierende Raumladungszone zum darüber liegenden Halbleitersubstrat 1 bzw. der darüber liegenden Wanne vom zweiten Leitungstyp p darstellt.

Obwohl gemäß Figur 5 die Vertiefung V unmittelbar unterhalb der Wortleitung WL ausgebildet ist und man dadurch eine selbstjustierende Kontaktierung zwischen der Steuerschicht 3 und dem Dioden-Dotiergebiet 4 erhält, kann diese Vertiefung auch an anderer Stelle realisiert werden und insbesondere auch im aktiven Gebiet AA angeordnet sein. Insbesondere bei der Anordnung der Vertiefung V im aktiven Gebiet AA ist darauf zu achten, dass zur Realisierung des Kondensators C zusätzlich an den Seitenwänden jedoch nicht im Bodenbereich der Vertiefung V eine dielektrische Schicht 6 ausgebildet wird, um eine elektrische Kontaktierung zum Halbleitersubstrat 1 zu verhindern.

Vorzugsweise besteht die Dioden-Anschlussschicht 5 aus hochdotiertem Halbleitermaterial (z.B. Polysilizium) vom ersten Leitungstyp n, wodurch sich das Dioden-Dotiergebiet 4 selbstjustierend im Bodenbereich der Vertiefung V in nachfolgenden thermischen Prozessschritten ausbilden kann. In gleicher Weise kann jedoch auch nach Ausbilden der Vertiefung V eine anderweitige Dotierung beispielsweise aus der Gasphase oder mittels Ionenimplantation durchgeführt werden und anschließend ein elektrisch leitendes Material in die Vertiefung V als Dioden-Anschlussschicht 5 aufgefüllt werden.

Figur 6 zeigt ein vereinfachtes Ersatzschaltbild der Halbleiter-Speicherzelle gemäß Figur 5, wobei gleiche Bezugszeichen gleiche oder entsprechende Elemente darstellen und auf eine wiederholte Beschreibung nachfolgend verzichtet wird.

Aus diesem Ersatzschaltbild sind die statischen (pn-Übergang) sowie dynamischen (Kapazität) Eigenschaften des Dioden-Dotiergebiets 4 sowie der zugehörigen Dioden-Anschlussschicht 5 ersichtlich, weshalb die Diode D sowie der Kondensator C an jeweilige Schaltungsbedingungen angepasst werden können.

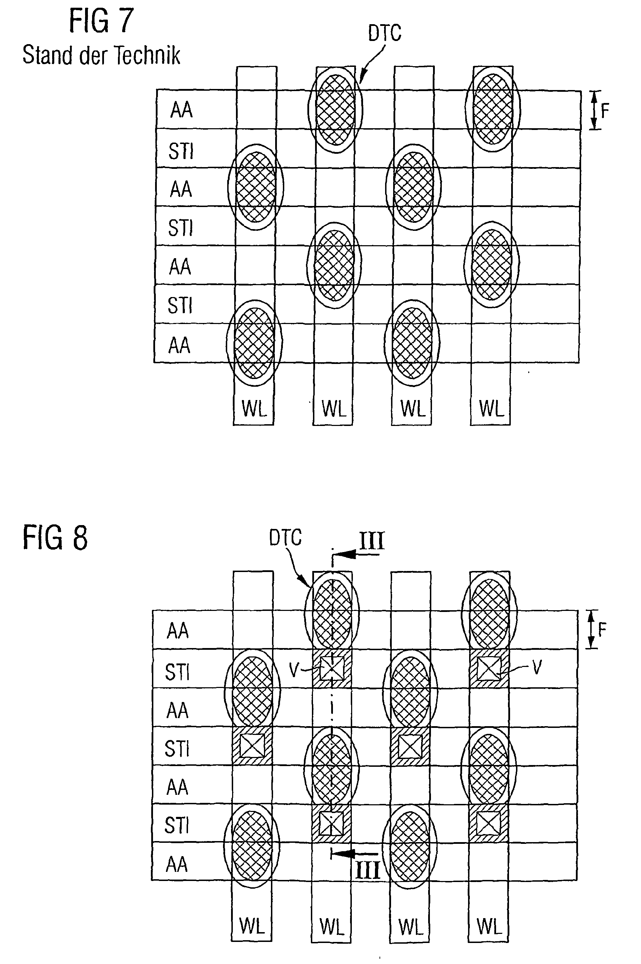

Figur 7 zeigt eine vereinfachte Draufsicht einer Halbleiter-Speicherzellenanordnung gemäß dem Stand der Technik und Figur 8 eine zugehörige Draufsicht einer Halbleiter-Speicherzellenanordnung gemäß einem zweiten Ausführungsbeispiel, wobei wiederum gleiche Bezugszeichen gleiche oder entsprechende Schichten bzw. Elemente wie in Figuren 1 und 2 darstellen, weshalb auf eine wiederholte Beschreibung nachfolgend verzichtet wird.

Gemäß Figur 7 können herkömmliche Halbleiter-Speicherzellen und insbesondere zugehörigen Grabenkondensatoren an einer Oberfläche eine größere Breite aufweisen als eine Breite eines aktiven Gebietes AA, weshalb die in Figur 2 dargestellte Positionierung der Vertiefungen V zu einem Kurzschluss mit dem Grabenkondensator DTC führen würde.

Gemäß Figur 8 werden demzufolge die Grabenkondensatoren DTC um maximal 0,5 F in Richtung einer angrenzenden Grabenisolierung STI verschoben, wobei F eine minimale lithografisch herstellbare Strukturbreite darstellt. Auf diese Weise wird die Grabenisolierung in ihrem Oberflächenbereich vollständig vom Grabenkondensator bzw. dessen oberen Bereich soweit freigelegt, dass die Vertiefung V wiederum, wie in Figur 8 dargestellt ist, innerhalb der Grabenisolierung STI ausgebildet werden kann. Vorzugsweise wird diese Verschiebung in einem Bereich von 0,25 bis 0,5 F durchgeführt, wodurch man eine ausreichend Isolation von der Vertiefung V zum Grabenkondensator DTC bei optimaler Flächenausnutzung erhält. Um eine ausreichende Isolation zum Grabenkondensator sicherzustellen, können hierbei zusätzlich zum verbleibenden STI-Oxid isolierende Spacerstrukturen in Form der dielektrischen Schicht 6 ausgebildet werden.

Bei der in Figuren 7 und 8 dargestellten ovalen Formen für einen Oberflächenquerschnitt des Grabenkondensators DTC ergibt sich ein weiterer Vorteil dahingehend, dass auf Grund der unterschiedlichen Krümmungsradien und dadurch hervorgerufenen unterschiedlichen Materialeigenschaften (Spannungen) in den Isolationsschichten und insbesondere in der GrabenIsolationsschicht 7 eine selbstjustierende Kontaktierung für den Grabenkondensator DTC realisiert werden kann.

Wie beim ersten Ausführungsbeispiel ermöglicht die unterhalb der Vertiefung V ausgebildete Diode wiederum eine DC-Kopplung bei negativen Wortleitung/Body-Spannungen, während der durch die Raumladungzone des pn-Übergangs und/oder die Dioden-Anschlussschicht sowie das Halbleitersubstrat ausgebildete Kondensator eine kapazitive Kopplung zwischen Body und Wortleitung für positive Wortleitung/Body-Spannungen ermöglicht.

Wiederum erzielt man demzufolge eine wesentliche Leistungsverbesserung, wenn die Halbleiter-Speicherzelle beschrieben wird, da man insbesondere durch die kapazitive Kopplung des Bodys an die Wortleitung einen ähnlichen Effekt wie bei einer sogenannten "Active-Well-Technik" erzielt. Genauer gesagt findet eine Erhöhung des Body-Potenzials statt, während man den Feldeffekttransistor durch einen Übergang der Wortleitung WL von einem niedrigen (LOW) zu einem höheren Potenzial (HIGH) aufsteuert. Daraus ergibt sich ein erhöhter Kanalstrom (Ladestrom) gegenüber einem herkömmlichen festen Wannenpotenzial. Diese kapazitive Kopplung geschieht zunächst über die sogenannte Junction-Kapazität des pn-Übergangs des Dioden-Dotiergebiets 4. Darüber hinaus kann jedoch diese kapazitive Kopplung, wie vorstehend beschreiben wurde, über das verbleibende STI-Oxid bzw. die dielektrische Schicht 6 an den Seitenwänden der Vertiefung V zur Realisierung des zusätzlichen Kondensators C verbessert werden.

In inaktiven Phasen stabilisiert die Wortleitung WL das Potenzial des Bodys bzw. Halbleitersubstrats. Hierbei wird durch das Wortleitungs-LOW-Potenzial über die Diode D eine obere Schwelle für das Wannenpotenzial bzw. das Potenzial des Halbleitersubstrats vorgegeben. Steigt das Potenzial der Wanne bzw. des Halbleitersubstrats durch verschiedene Leckströme (z.B. Junction Leakage) über diese vorgegebene Schwelle an, so werden über den pn-Übergang bzw. das Dioden-Dotiergebiet 4 Elektronen injiziert, die mit den überschüssigen Löchern im Body rekombinieren.

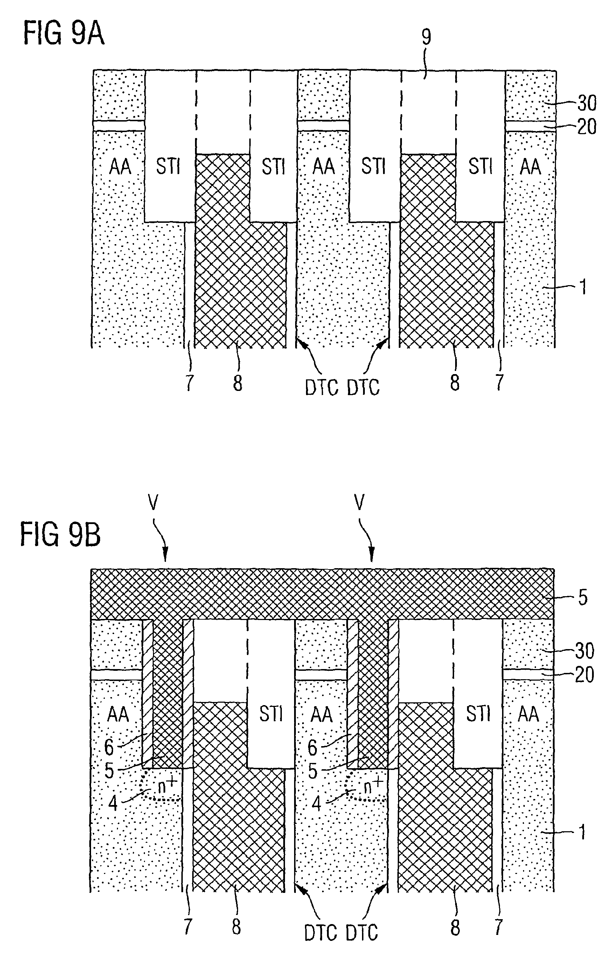

Figuren 9A bis 9F zeigen vereinfachte Schnittansichten entlang eines Schnitts III-III in Figur 8 zur Veranschaulichung wesentlicher Verfahrensschritte bei der Herstellung einer Halbleiterstruktur gemäß dem zweiten Ausführungsbeispiel, wobei wiederum gleiche Bezugszeichen gleiche oder entsprechende Elemente bzw. Schichten wie in Figuren 1 bis 8 bezeichnen und auf eine wiederholte Beschreibung nachfolgend verzichtet wird.

Gemäß Figur 9A werden zunächst nach beispielsweise einem Standard-DRAM-Prozess in einem Halbleitersubstrat 1 Grabenkondensatoren DTC mit ihren dargestellten Grabenkondensator-Anschlussschichtbereichen 8 und Isolationskragenschichten 7 in üblicher Weise dargestellt. Abhängig von einem jeweils verwendeten Standardprozess besteht hierbei die Grabenkondensator-Anschlussschicht 8 vorzugsweise aus hoch dotiertem Polysilizium und die Grabenisolationsschicht 7 aus Siliziumoxid.

Unter Verwendung einer aus einer PAD-Oxidschicht 20 und einer PAD-Nitridschicht 30 bestehenden Maskenschicht werden ferner Grabenisolierungen STI zum Festlegen von aktiven Gebieten AA an der Oberfläche des Halbleitersubstrats ausgebildet. Vorzugsweise werden die Grabenisolierungen STI mit einem herkömmlichen STI-Prozess zur Realisierung von flachen Grabenisolierung ausgebildet, wobei eine Siliziumdioxidschicht (TEOS) abgeschieden wird. Zur Passivierung bzw. zur Isolierung der im Wesentlichen in den aktiven Gebieten AA ausgebildeten Grabenkondensatoren DTC werden an diesen Stellen zusätzlich Top-Isolierschichten 9 ausgebildet, die wiederum vorzugsweise Siliziumdioxid aufweisen. Mittels eines derartigen Standardprozesses erhält man das in Figur 9A dargestellte und entsprechend vorbereitete Halbleitersubstrat.

Gemäß Figur 9B werden nunmehr in einem nachfolgenden Schritt die Vertiefungen V derart in vorbestimmten Bereichen der Grabenisolierung STI ausgebildet, dass sie die Grabenisolierung vollständig durchstoßen und bis ins Halbleitersubstrat 1 reichen. Zur Realisierung dieser Vertiefungen V kann beispielsweise eine herkömmliche Maske verwendet werden, wie sie bei der Herstellung von Kontaktlöchern bzw. Vias verwendet wird, wobei vorzugsweise ein entsprechendes anisotropes Oxid-Ätzverfahren durchgeführt wird.

Bei einer entsprechend hohen Justiergenauigkeit für diese Vertiefungen V erhält man an den Seitenwänden der Vertiefungen V ausreichend dicke Isolierschichten, die vom STI-Oxid übrig bleiben. Sind jedoch an die Justiergenauigkeit für die Vertiefungen V geringere Anforderungen gestellt, so kann in einem nachfolgenden Prozessschritt optional eine dielektrische Schicht 6 an den Seitenwänden der Vertiefung V ausgebildet werden, wobei vorzugsweise mittels eines herkömmlichen Spacerverfahrens eine dünne Siliziumdioxidschicht konform, d.h. mit gleicher Dicke abgeschieden und anschließend anisotrop zurückgeätzt wird.

Nach dem Ausbilden der Vertiefung V bzw. nach dem optionalen Ausbilden der zusätzlichen dielektrischen Schicht 6 kann gemäß einer ersten Ausführungsform zunächst eine Dotierung des Halbleitersubstrats 1 im Bereich des Bodens der Vertiefung V durchgeführt werden, wobei beispielsweise eine Gasphasendotierung, insbesondere jedoch eine Ionenimplantation durchgeführt wird. Auf diese Weise entstehen die in Figur 9B dargestellten Dioden-Dotiergebiete vom ersten Leitungstyp, die vorzugsweise hoch dotiert sind.

Anschließend erfolgt gemäß der ersten Ausführungsform das Ausbilden eines elektrisch leitenden Füllmaterials als Dioden-Anschlussschicht 5 in der Vertiefung V, wobei beispielsweise ein elektrisch leitendes Material ganzflächig abgeschieden und anschließend bis zur Oberfläche der Vertiefung V z.B. mittels eines CMP-Verfahrens (Chemical Mechanical Polishing) planarisiert wird.

Gemäß einer zweiten bevorzugten Ausführungsform wird jedoch keine Dotierung aus der Gasphase bzw. Ionenimplantation durchgeführt, sondern unmittelbar nach dem Ausbilden der Vertiefung V bzw. nach Ausbilden der elektrisch isolierenden Seitenwände 6 ein dotiertes Halbleitermaterial als Dioden-Anschlussschicht 5 zumindest in der Vertiefung V ausgebildet, wobei vorzugsweise ein hoch dotiertes polykristallines Halbleitermaterial wie z.B. Polysilizium vom ersten Leitungstyp ganzflächig abgeschieden und anschließend planarisiert wird.

Das Ausbilden der Dioden-Dotiergebiete 4 erfolgt hierbei automatisch und ohne zusätzlichen Prozessschritt durch Ausdiffusion von Dotierstoffen aus der Dioden-Anschlussschicht 5 bei einer nachfolgend durchgeführten thermischen Behandlung, die üblicherweise in späteren Prozessschritten ohnehin notwendig ist. Auf diese Weise können die Dioden-Dotiergebiete auf besonders einfache Art und Weise hergestellt werden.

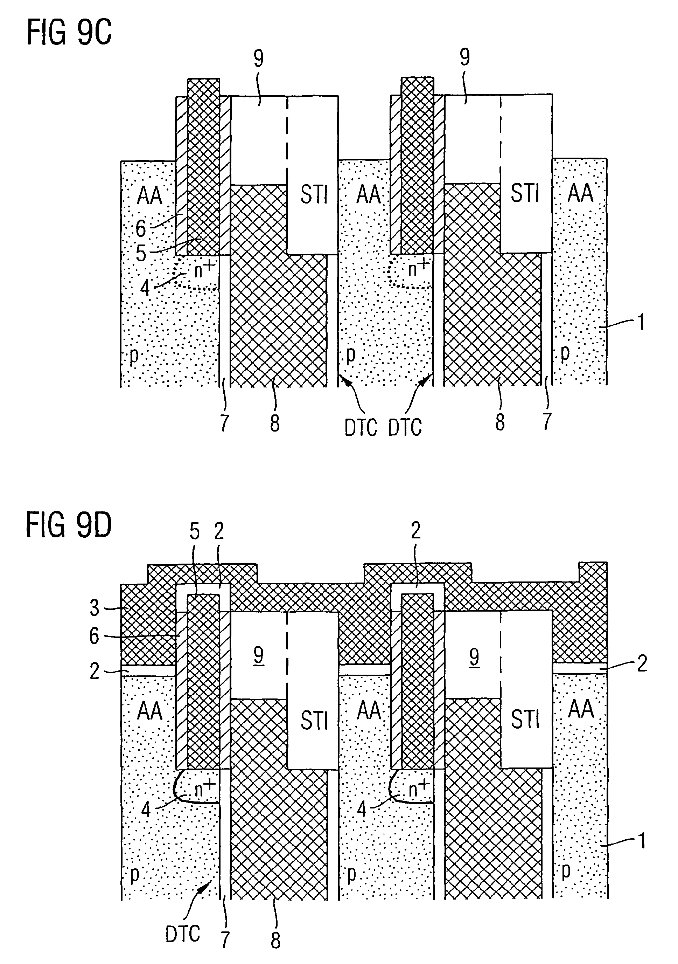

Gemäß Figur 9C wird nach dem Planarisieren bzw. Entfernen der an der Oberfläche abgeschiedenen Dioden-Anschlussschicht 5 auch die Maskenschicht entfernt, wobei im dargestellten Ausführungsbeispiel die PAD-Nitridschicht 30 mittels eines Nitridätzverfahrens und die PAD-Oxidschicht 20 mittels eines Oxidätzverfahrens selektiv entfernt wird. Optional kann zu diesem Zeitpunkt beispielsweise eine Wannenimplantation durchgeführt werden, wobei zunächst eine nicht dargestellte Opfer-Isolationsschicht ganzflächig ausgebildet, anschließend eine Ionenimplantation durchgeführt wird und abschließend die Opfer-Isolationsschicht wieder entfernt wird. Auf diese Weise erhält man eine Wanne bzw. ein Halbleitersubstrat 1 vom zum ersten Leitungstyp n entgegengesetzten Leitungstyp p in den aktiven Gebieten AA. Bei einfachen Strukturen können derartige Wannenimplantationen jedoch auch fehlen und es genügt eine bereits vorhandene Dotierung vom entgegengesetzten Leitungstyp p im Halbleitersubstrat 1.

Gemäß Figur 9D wird anschließend die Gate-Isolationsschicht 2 zumindest an der Oberfläche der aktiven Gebiete AA ausgebildet, wobei vorzugsweise eine thermische Oxidation alle freiliegenden Halbleiterbereiche zur Realisierung eines hochwertigen Gateoxids umwandelt. Gemäß Figur 9D werden demzufolge nicht nur die freiliegenden Bereiche der aktiven Gebiete AA, sondern auch die freiliegenden Gebiete der aus Polysilizium bestehenden Dioden-Anschlussschicht 5 mit dieser Isolierschicht bedeckt. Da diese thermische Oxidation bereits eine thermische Nachbehandlung zur Realisierung des Dioden-Dotiergebiets 4 darstellt, werden demzufolge spätestens zu diesem Zeitpunkt die Dioden-Dotiergebiete 4 tatsächlich mittels Ausdiffusion im Halbleitersubstrat 1 realisiert bzw. durch Ionenimplantation gestörte Halbleiterbereiche geheilt.

Anschließend wird gemäß Figur 9D die Steuerschicht 3 zumindest an der Oberfläche der Gate-Isolationsschicht 2 ausgebildet, wobei vorzugsweise ein ganzflächiges Abscheiden eines elektrisch leitenden Materials und insbesondere von hoch dotiertem Polysilizium wiederum vom ersten Leitungstyp durchgeführt wird.

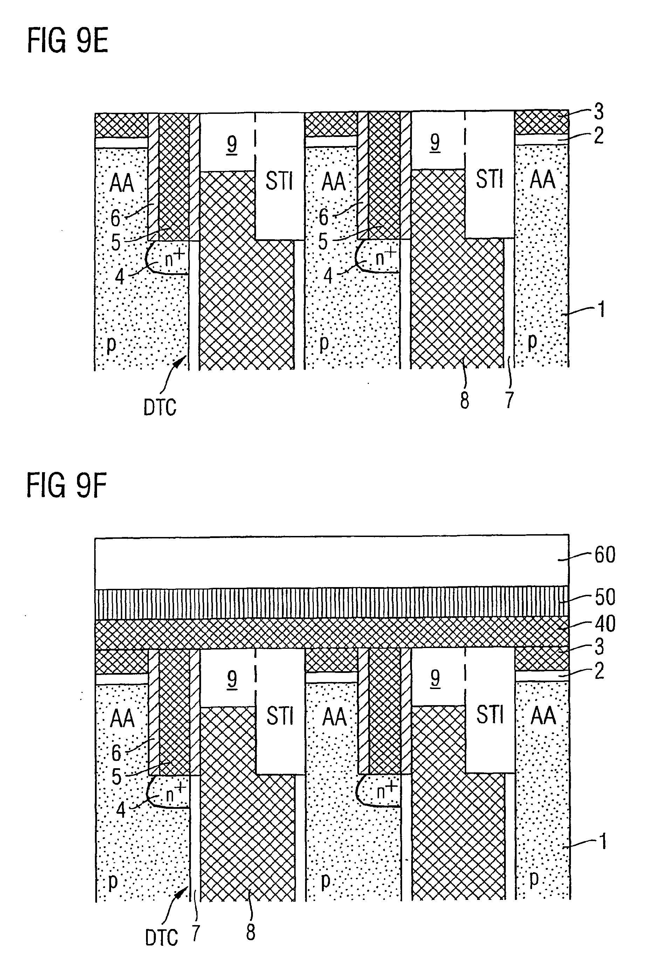

Gemäß Figur 9E erfolgt nachfolgend wiederum ein Planarisierungsschritt, bei dem ca. 20 bis 30 Nanometer oberhalb des Halbleitersubstrats 1 gestoppt wird. Vorzugsweise erfolgt ein CMP-Verfahren zum Planarisieren der hergestellten Oberfläche bis zumindest zur Grabenisolierung STI, wodurch sowohl eine Oberfläche der Steuerschicht 3 als auch eine Oberfläche der Dioden-Anschlussschicht 5 freigelegt wird.

Abschließend wird gemäß Figur 9F eine elektrisch leitende Verbindungsschicht zum Verbinden der Steuerschicht 3 mit der Dioden-Anschlussschicht 5 ausgebildet. Vorzugsweise wird hierbei zunächst eine weitere hoch dotierte Halbleiterschicht vom ersten Leitungstyp ganzflächig abgeschieden, wobei vorzugsweise ein n⁺-dotiertes Polysilizium 40 verwendet wird. Anschließend kann zur weiteren Verbesserung der elektrischen Leitfähigkeit dieser Verbindungsschicht und zur Realisierung von hochleitfähigen Anschlussbereichen für diese erste Verbindungsschicht 40 silizierfähiges Material bzw. eine silizierfähige Metallschicht ganzflächig abgeschieden werden. Abschließend wird hierbei eine Umwandlung der Oberflächenschicht des Halbleitermaterials 40 unter Verwendung des silizierfähigen Materials 50 zum Ausbilden einer hochleitfähigen Verbindungsschicht durchgeführt, wobei an den nicht im Halbleitermaterial (Silizium) in Berührung stehenden Oberflächen kein Silizid (Silicide) ausgebildet wird, sondern das abgeschiedene Material (Metall) bestehen bleibt, weshalb wiederum mittels eines vorzugsweise nasschemischen Ätzverfahrens eine selektive Rückätzung der abgeschiedenen Schichten sehr leicht erfolgen kann. Neben der Verwendung von Kobalt, Nickel oder Platin wird insbesondere Wolfram zur Ausbildung einer Wolframsilizidschicht 50 hierbei abgeschieden.

Nachfolgend erfolgt eine ganzflächige Abscheidung von beispielsweise Siliziumnitrid als weiterer Masken- oder Passivierungsschicht 60. Die weiteren Prozessschritte zur Fertigstellung der DRAM-Halbleiter-Speicherzelle bzw. der Feldeffekttransistorstruktur entsprechen den Standardprozessschritten, weshalb auf eine detaillierte Beschreibung nachfolgend verzichtet wird. Im Wesentlichen erfolgen aber nunmehr die Ätzung der Gate-Stapel bzw. der Wortleitungen WL, das Ausbilden der Source-/Draingebiete S/D und das Ausbilden der Bitleitungen BL mit ihren zugehörigen Kontakten BLK zu den jeweiligen Source-/Draingebieten.

Die Erfindung wurde vorstehend anhand einer DRAM-Halbleiter-Speicherzelle beschrieben. Sie ist jedoch nicht darauf beschränkt und umfasst in gleicher Weise alle weiteren Feldeffekttransistorstrukturen sowie zugehörige Halbleiter-Speicherzellen und zugehörige Herstellungsverfahren, bei denen eine Verschlechterung von elektrischen Eigenschaften auf Grund eines sogenannten Body-Effekts zu beobachten ist.

In gleicher Weise sind an Stelle der verwendeten Materialien auch alternative Halbleiter sowie Isolationsmaterialien zu verwenden, sofern sie die gleichen Eigenschaften aufweisen.

## Patentansprüche

1. Feldeffekttransistorstruktur mit
einem ersten und zweiten Source-/Draingebiet (S/D) von einem ersten Leitungstyp (n), die in einem Halbleitersubstrat (1) von einem zum ersten Leitungstyp (n) entgegengesetzten zweiten Leitungstyp (p) zum Festlegen eines Kanalgebiets (K) ausgebildet sind;
einer Gate-Isolationsschicht (2), die an der Oberfläche des Kanalgebiets (K) ausgebildet ist;
einer Steuerschicht (3), die an der Oberfläche der Gate-Isolationsschicht (2) ausgebildet ist;
einem Dioden-Dotiergebiet (4) vom ersten Leitungstyp (n), das zum Realisieren einer Diode (D) im Halbleitersubstrat (1) ausgebildet ist,
einer elektrisch leitenden Dioden-Anschlussschicht (5), die zum Abführen von überschüssigen Ladungsträgern (L) im Halbleitersubstrat (1) das Dioden-Dotiergebiet (4) an die Steuerschicht (3) anschließt, und
einer im Halbleitersubstrat (1) ausgebildeten Vertiefung (V), wobei
das Dioden-Dotiergebiet (4) am Boden der Vertiefung (V) und die Dioden-Anschlussschicht (5) in der Vertiefung (V) ausgebildet sind,
**dadurch gekennzeichnet, dass**
eine dielektrische Schicht (6) an den Wänden der Vertiefung (V) zwischen der Dioden-Anschlussschicht (5) und dem Halbleitersubstrat (1) zum Realisieren eines mit der Steuerschicht (3) verbundenen Kondensators (C) ausgebildet ist.

2. Feldeffekttransistorstruktur nach Patentanspruch 1,
**dadurch gekennzeichnet, dass** die Vertiefung (V) unmittelbar neben dem Kanalgebiet (K) ausgebildet ist.

3. Feldeffekttransistorstruktur nach Patentanspruch 2,
**dadurch gekennzeichnet, dass** die Vertiefung (V) in einer flachen Grabenisolierung (STI) ausgebildet ist.

4. Feldeffekttransistorstruktur nach einem der Patentansprüche 1 bis 3
**dadurch gekennzeichnet, dass** die Dioden-Anschlussschicht (5) dotiertes Halbleitermaterial vom ersten Leitungstyp (n) aufweist.

5. Halbleiterspeicherzelle mit einem Auswahltransistor nach einem der Patentansprüche 1 bis 4,
**dadurch gekennzeichnet, dass** das erste Source-/Draingebiet (S/D) mit einem Grabenkondensator (DTC) verbunden ist;
das zweite Source-/Draingebiet (S/D) mit einer Bitleitung (BL) verbunden ist; und
die Steuerschicht (3) einen Teil einer Wortleitung (WL) darstellt, die senkrecht zur Bitleitung (BL) verläuft, wobei
das Dioden-Dotiergebiet (4) unterhalb der Wortleitung (WL) im Halbleitersubstrat (1) ausgebildet ist.

6. Halbleiter-Speicherzelle nach Patentanspruch 5,
**dadurch gekennzeichnet, dass** eine vergrabene Anschlussplatte (BP) zum Anschließen einer Gegenelektrode des Grabenkondensators (DTC) im Halbleitersubstrat (1) ausgebildet ist, wobei sich das Dioden-Dotiergebiet (4) zwischen der Anschlussplatte (BP) und der Oberfläche des Halbleitersubstrats (1) befindet.

7. Halbleiter-Speicherzelle nach Patentanspruch 3 und 5 oder 3 und 6,
**dadurch gekennzeichnet, dass** die Grabenisolierung (STI) streifenförmig im Halbleitersubstrat (1) zum Ausbilden von streifenförmigen aktiven Gebieten (AA) ausgebildet ist, wobei der Grabenkondensator (DTC) zumindest teilweise im aktiven Gebiet (AA) liegt.

8. Halbleiter-Speicherzelle nach Patentanspruch 7,
**dadurch gekennzeichnet, dass** der Grabenkondensator (DTC) an seiner Oberfläche eine Breite aufweist, die größer ist als eine Breite des aktiven Gebietes (AA), wobei zum Freilegen einer an das aktive Gebiet (AA) angrenzenden Grabenisolierung (STI) der Grabenkondensator (DTC) in eine weitere angrenzende Grabenisolierung (FTI) verschoben wird.

9. Halbleiter-Speicherzelle nach Patentanspruch 8,
**dadurch gekennzeichnet, dass** ein Oberflächenquerschnitt des Grabenkondensators (DTC) eine ovale Form aufweist.

10. Halbleiter-Speicherzelle nach einem der Patentansprüche 5 bis 9,
**dadurch gekennzeichnet, dass** sie eine DRAM-Speicherzelle darstellt.

11. Verfahren zur Herstellung einer Halbleiterstruktur mit den Schritten:
a) Vorbereiten eines Halbleitersubstrats (1) mit zumindest einer Grabenisolierung (STI), einem aktiven Gebiet (AA) und einer zugehörigen Maskenschicht (20, 30);
b) Ausbilden einer Vertiefung (V) in der Grabenisolierung (STI), die bis zum Halbleitersubstrat (1) reicht und eine dielektrische Schicht (6) für einen Kondensator (C) an den Wänden der Vertiefung (V) aufweist;
c) Ausbilden eines Dioden-Dotiergebiets (4) am Boden der Vertiefung (V) im Halbleitersubstrat (1) und einer elektrisch leitenden Dioden-Anschlussschicht (5) zum Auffüllen der Vertiefung (V) und Realisieren eines Kondensators (C) zusammen mit der dielektrischen Schicht (6) und dem Halbleitersubstrat (1) ;
d) Entfernen der Maskenschicht (20, 30);
e) Ausbilden einer Gate-Isolationsschicht (2) zumindest an der Oberfläche des aktiven Gebietes (AA);
f) Ausbilden einer Steuerschicht (3) zumindest an der Oberfläche der Gate-Isolationsschicht (2);
g) Planarisieren der hergestellten Oberfläche bis zumindest zur Grabenisolierung (STI); und
h) Ausbilden einer elektrisch leitenden Verbindungsschicht (40, 50) zum Verbinden der Steuerschicht (3) mit der Dioden-Anschlussschicht (5) und dem Kondensator (C) .

12. Verfahren nach Patentanspruch 11,
**dadurch gekennzeichnet, dass** in Schritt a) ferner ein Grabenkondensator (DTC) im Halbleitersubstrat (1) zur Realisierung einer Halbleiter-Speicherzelle ausgebildet ist.

13. Verfahren nach Patentanspruch 11 oder 12,
**dadurch gekennzeichnet, dass** in Schritt a) eine PAD-Oxidschicht (20) und eine PAD-Nitridschicht (30) als Maskenschicht ausgebildet sind.

14. Verfahren nach einem der Patentansprüche 11 bis 13,
**dadurch gekennzeichnet, dass** in Schritt b) ein anisotropes Oxid-Ätzverfahren zum Ausbilden der Vertiefung (V) durchgeführt wird.

15. Verfahren nach Patentanspruch 14,
**dadurch gekennzeichnet, dass** in Schritt b) ein Spacer-Verfahren zum Ausbilden der dielektrischen Schicht (6) an den Seitenwänden der Vertiefung (V) durchgeführt wird.

16. Verfahren nach einem der Patentansprüche 11 bis 15,
**dadurch gekennzeichnet, dass** in Schritt c) ein dotiertes Halbleitermaterial als Dioden-Anschlussschicht (5) in der Vertiefung (V) abgeschieden wird und
eine thermische Behandlung zum Ausdiffundieren von Dotierstoffen aus der Dioden-Anschlussschicht (5) am Boden der Vertiefung (V) zum Erzeugen des Dioden-Dotiergebiets (4) durchgeführt wird.

17. Verfahren nach einem der Patentansprüche 11 bis 15,
**dadurch gekennzeichnet, dass** in Schritt c) zunächst eine Implantation zum Erzeugen des Dioden-Dotiergebiets (4) durchgeführt wird und
anschließend ein elektrisch leitendes Füllmaterial als Dioden-Anschlussschicht (5) in der Vertiefung (V) abgeschieden wird.

18. Verfahren nach einem der Patentansprüche 11 bis 17,
**dadurch gekennzeichnet, dass** vor Schritt e) eine Implantationsschutzschicht ausgebildet, eine Wannenimplantation durchgeführt, und
die Implantationsschutzschicht entfernt wird.

19. Verfahren nach einem Patentansprüche 11 bis 18,
**dadurch gekennzeichnet, dass** in Schritt e) eine Oxidschicht (2) als Gate-Isolationsschicht thermisch ausgebildet wird.

20. Verfahren nach einem der Patentansprüche 11 bis 19,
**dadurch gekennzeichnet, dass** in Schritt h) eine dotierte Halbleiterschicht (40) und eine silizierfähige Metallschicht (50) als Verbindungsschicht ausgebildet wird.

21. Verfahren nach einem der Patentansprüche 11 bis 20,
**gekennzeichnet durch** den weiteren Schritt i) Weiterprozessieren der Halbleiterstruktur zum Ausbilden eines Feldeffekttransistors oder einer DRAM-Halbleiter-Speicherzelle mit zumindest einer Wortleitung (WL) und zumindest einer Bitleitung (BL).

## Claims

1. Field-effect transistor structure having
a first and second source/drain region (S/D) of a first conduction type (n), which are formed in a semiconductor substrate (1) of a second conduction type (p), opposite to the first conduction type (n), for the purpose of defining a channel region (K);
a gate insulation layer (2) formed at the surface of the channel region (K);
a control layer (3) formed at the surface of the gate insulation layer (2);
a diode doping region (4) of the first conduction type (n), which is formed for the purpose of realizing a diode (D) in the semiconductor substrate (1),
an electrically conductive diode connection layer (5), which connects the diode doping region (4) to the control layer (3) for the purpose of dissipating excess charge carriers (L) in the semiconductor substrate (1), and a depression (V) formed in the semiconductor substrate (1), the diode doping region (4) being formed at the bottom of the depression (V) and the diode connecting layer (5) being formed in the depression (V),
**characterized in that**
a dielectric layer (6) is formed at the walls of the depression (V) between the diode connection layer (5) and the semiconductor substrate (1) for the purpose of realizing a capacitor (C) connected to the control layer (3).

2. Field-effect transistor structure according to Patent Claim 1,
**characterized in that** the depression (V) is formed directly beside the channel region (K).

3. Field-effect transistor structure according to one of Patent Claim 2,
**characterized in that** the depression (V) is formed in a shallow trench isolation (STI).

4. Field-effect transistor structure according to one of Patent Claims 1 to 3,
**characterized in that** the diode connection layer (5) has doped semiconductor material of the first conduction type (n).

5. Semiconductor memory cell having a selection transistor according to one of Patent Claims 1 to 4,
**characterized in that** the first source/drain region (S/D) is connected to a trench capacitor (DTC);
the second source/drain region (S/D) is connected to a bit line (BL); and
the control layer (3) constitutes a part of a word line (WL) running perpendicular to the bit line (BL),
the diode doping region (4) being formed below the word line (WL) in the semiconductor substrate (1).

6. Semiconductor memory cell according to Patent Claim 5,
**characterized in that** a buried connection plate (BP) for connecting a counterelectrode of the trench capacitor (DTC) is formed in the semiconductor substrate (1), the diode doping region (4) being situated between the connection plate (BP) and the surface of the semiconductor substrate (1).

7. Semiconductor memory cell according to Patent Claims 3 and 5 or 3 and 6,
**characterized in that** the trench isolation (STI) is formed in strip-type fashion in the semiconductor substrate (1) for the purpose of forming strip-type active regions (AA), the trench capacitor (DTC) at least partially lying in the active region (AA).

8. Semiconductor memory cell according to Patent Claim 7,
**characterized in that** the trench capacitor (DTC) has at its surface a width which is greater than a width of the active region (AA), in which case, in order to uncover a trench isolation (STI) adjoining the active region (AA), the trench capacitor (DTC) is displaced into a further adjoining trench isolation (FTI).

9. Semiconductor memory cell according to Patent Claim 8,
**characterized in that** a surface cross section of the trench capacitor (DTC) has an oval form.

10. Semiconductor memory cell according to one of Patent Claims 5 to 9,
**characterized in that** it constitutes a DRAM memory cell.

11. Method for fabricating a semiconductor structure having the following steps:
a) preparation of a semiconductor substrate (1) with at least one trench isolation (STI), an active region (AA) and an associated mask layer (20, 30);
b) formation of a depression (V) in the trench isolation (STI), which extends as far as the semiconductor substrate (1) and has a dielectric layer (6) for a capacitor (C) at the walls of the depression (V);
c) formation of a diode doping region (4) at the bottom of the depression (V) in the semiconductor substrate (1) and of an electrically conductive diode connection layer (5) for filling the depression (V) and realizing a capacitor (C) together with the dielectric layer (6) and the semiconductor substrate (1);
d) removal of the mask layer (20, 30);
e) formation of a gate insulation layer (2) at least at the surface of the active region (AA);
f) formation of a control layer (3) at least at the surface of the gate insulation layer (2);
g) planarization of the fabricated surface at least as far as the trench isolation (STI); and
h) formation of an electrically conductive connecting layer (40, 50) for connecting the control layer (3) to the diode connection layer (5) and the capacitor (C).

12. Method according to Patent Claim 11,
**characterized in that**, in step a) a trench capacitor (DTC) is furthermore formed in the semiconductor substrate (1) for the purpose of realizing a semiconductor memory cell.

13. Method according to Patent Claim 11 or 12,
**characterized in that**, in step a) a PAD oxide layer (20) and a PAD nitride layer (30) are formed as mask layer.

14. Method according to one of Patent Claims 11 to 13,
**characterized in that**, in step b), an anisotropic oxide etching method is carried out for the purpose of forming the depression (V).

15. Method according to Patent Claim 14,
**characterized in that**, in step b) a spacer method is carried out for the purpose of forming the dielectric layer (6) at the sidewalls of the depression (V).

16. Method according to one of Patent Claims 11 to 15,
**characterized in that**, in step c), a doped semiconductor material is deposited as diode connection layer (5) in the depression (V) and a thermal treatment is carried out for the purpose of outdiffusion of dopants from the diode connection layer (5) at the bottom of the depression (V) for the purpose of producing the diode doping region (4).

17. Method according to one of Patent Claims 11 to 15,
**characterized in that**, in step c), firstly an implantation is carried out for the purpose of producing the diode doping region (4), and
an electrically conductive filling material is subsequently deposited as diode connection layer (5) in the depression (V).

18. Method according to one of Patent Claims 11 to 17,
**characterized in that**, before step e) an implantation protection layer is formed, a well implantation is carried out and the implantation protection layer is removed.

19. Method according to one of Patent Claims 11 to 18,
**characterized in that**, in step e), an oxide layer (2) is formed thermally as gate insulation layer.

20. Method according to one of Patent Claims 11 to 19,
**characterized in that**, in step h), a doped semiconductor layer (40) and a siliconizable metal layer (50) are formed as connecting layer.

21. Method according to one of Patent Claims 11 to 20,
**characterized by** the following further step:
i) further processing of the semiconductor structure for the purpose of forming a field-effect transistor or a DRAM semiconductor memory cell with at least one word line (WL) and at least one bit line (BL).

## Revendications

1. Structure de transistor à effet de champ, comprenant
une première et une deuxième zones (S/D) source-/drain d'un premier type (n) de conductivité, qui sont formées pour fixer une zone (K) de canal formée dans un substrat (1) semi-conducteur d'un deuxième type (p) de conductivité opposé au premier type (n) de conductivité ;
une couche (2) isolante de grille, qui est formée à la surface de la zone (K) de canal ;
une couche (3) de commande, qui est formée à la surface de la couche (2) isolante de grille ;
une zone (4) dopée de diode du premier type (n) de conductivité, qui est formée pour réaliser une diode (D) par le substrat (1) semi-conducteur,
une couche (5) conductrice de l'électricité de borne de diode, qui, pour l'évacuation de porteurs (L) de charge superflus dans le substrat (1) semi-conducteur, raccorde la zone (4) de dopage de diode à la couche (3) de commande, et
une cavité (V) formée dans le substrat (1) semi-conducteur, dans laquelle
la zone (4) de dopage de diode est formée au fond de la cavité (V) et la couche (5) de borne de diode est formée dans la cavité (V),
**caractérisée en ce que**
une couche (6) diélectrique est formée sur les parois de la cavité (V) entre la couche (5) de borne de diode et le substrat (1) semi-conducteur pour réaliser un condensateur (C) relié à la couche (3) de commande.

2. Structure de transistor à effet de champ suivant la revendication 1,
**caractérisée en ce que** la cavité (V) est formée directement à côté de la zone (K) de canal.

3. Structure de transistor à effet de champ suivant la revendication 2,
**caractérisée en ce que** la cavité (V) est formée dans un isolant (STI) plat à sillon.

4. Structure de transistor à effet de champ suivant l'une des revendications 1 à 3,
**caractérisée en ce que** la couche (5) de borne de diode a du matériau semi-conducteur dopé du premier type (n) de conductivité.

5. Cellule de mémoire à semi-conducteurs ayant un transistor de sélection suivant l'une des revendications 1 à 4,
**caractérisée en ce que** la première zone (S/D) de source-/drain est reliée à un condensateur (DTC) à sillon ;
la deuxième zone (S/D) de source-/drain est reliée à une ligne (BL) de bits ; et
la couche (3) de commande constitue une partie d'une ligne (WL) de mots, qui est perpendiculaire à ligne (BL) de bits, la zone (4) de dopage de diode étant formée en dessous de la ligne (WL) de mots dans le substrat (1) semi-conducteur.

6. Cellule de mémoire à semi-conducteurs suivant la revendication 5,
**caractérisée en ce qu'**une plaque dopée enterrée de connexion pour la connexion d'une contre-électrode du condensateur (DTC) à sillon, est formée dans le substrat (1) semi-conducteur, la zone (4) de dopage de diode se trouvant entre la plaque (BP) de connexion et la surface de substrat (1) semi-conducteur.

7. Cellule de mémoire à semi-conducteurs suivant les revendications 3 et 5 ou 3 et 6,
**caractérisée en ce que** l'isolant (STI) à sillon est formé en forme de bandes dans le substrat (1) semi-conducteur pour former des zones (AA) actives en forme de bandes, le condensateur (DTC) à sillon se trouvant au moins en partie dans la zone (AA) active.

8. Cellule de mémoire à semi-conducteurs suivant la revendication 7,
**caractérisée en ce que** le condensateur (DTC) à sillon a à sa surface une largeur qui est plus grande qu'une largeur de la zone (AA) active, dans laquelle, pour mettre à nu un isolant (STI) à sillon voisin de la zone (AA) active, le condensateur (DTC) à sillon est décalé dans un autre isolant (STI) à sillon voisin.

9. Cellule de mémoire à semi-conducteurs suivant la revendication 8,
**caractérisée en ce qu'**une section transversale de surface du condensateur (DTC) à sillon a une forme ovale.

10. Cellule de mémoire à semi-conducteurs suivant l'une des revendications 5 à 9,
**caractérisée en ce qu'**elle constitue une cellule de mémoire DRAM.

11. Procédé de fabrication d'une structure à semi-conducteurs comprenant les stades dans lesquels :
a) On prépare un substrat (1) semi-conducteur ayant au moins un isolant (STI) à sillon, une zone (AA) active et une couche de masque (20, 30) associée ;
b) On forme dans l'isolant (STI) à sillon une cavité (V), qui va jusqu'au substrat (1) semi-conducteur et qui a une couche (6) diélectrique pour un condensateur (C) sur les parois de la cavité (V) ;
c) On forme une zone (4) de dopage de diode au fond de la cavité (V) dans le substrat (1) semi-conducteur et une couche (5) conductrice de l'électricité de borne de diode pour remplir la cavité () et réaliser un condensateur (C) ensemble avec la couche (6) diélectrique et le substrat (1) semi-conducteur ;
d) On enlève la couche (20, 30) de masque ;
e) On forme une couche (2) isolante de grille au moins à la surface de la zone (AA) active ;
f) On forme une couche (3) de commande au moins à la surface de la couche (2) isolante de grille ;
g) On planarise la surface préparée jusqu'à au moins l'isolant (STI) à sillon ;
h) On forme une couche (40, 50) conductrice de l'électricité de liaison pour relier la couche (3) de commande à la couche (5) de borne de diode et au condensateur (C).

12. Procédé suivant la revendication 11,
**caractérisé en ce que**, dans le stade a), on forme, en outre, un condensateur (DTC) à sillon dans le substrat (1) semi-conducteur pour la réalisation d'une cellule de mémoire à semi-conducteurs.

13. Procédé suivant la revendication 11 ou 12,
**caractérisé en ce que**, dans le stade a), on forme une couche (20) d'oxyde PAD et une couche (30) de nitrure PAD comme couche de masque.

14. Procédé suivant l'une des revendications 11 à 13,
**caractérisé en ce que**, dans le stade b), on effectue un procédé d'attaque d'oxyde anisotrope pour la formation de la cavité (V).

15. Procédé suivant la revendication 14,
**caractérisé en ce que**, dans le stade b), on effectue un procédé à espaceur pour la formation de la couche (6) diélectrique sur les parois latérales de la cavité (V).

16. Procédé suivant l'une des revendications 11 à 15,
**caractérisé en ce que**, dans le stade c), on dépose un matériau semi-conducteur dopé comme couche (5) de borne de diode dans la cavité (V) et on effectue un traitement thermique pour faire diffuser de la substance de dopage de la couche (5) de borne de diode au fond de la cavité (V) afin de produire la zone (4) de dopage de diode.

17. Procédé suivant l'une des revendications 11 à 15,
**caractérisé en ce que**, dans le stade c), on effectue d'abord une implantation pour produire la zone (4) de dopage de diode et
on dépose ensuite un matériau de remplissage conducteur de l'électricité comme couche (5) de borne de diode dans la cavité (V).

18. Procédé suivant l'une des revendications 11 à 17,
**caractérisé en ce que**, dans le stade e), on forme une couche de protection de l'implantation, on effectue une implantation à cuvette et
on élimine la couche de protection de l'implantation.

19. Procédé suivant l'une des revendications 11 à 18,
**caractérisé en ce que**, dans le stade e), on forme thermiquement une couche d'oxyde comme couche isolante de grille.

20. Procédé suivant l'une des revendications 11 à 19,
**caractérisé en ce que**, dans le stade h), on forme une
couche (40) semi-conductrice dopée et une couche (50) métallique susceptible d'être siliciée comme couche de liaison.

21. Procédé suivant l'une des revendications 11 à 20,
**caractérisé en ce que**, par le stade i) supplémentaire, on effectue des traitements supplémentaires de la structure à semi-conducteurs pour former un transistor à effet de champ ou une cellule de mémoire à semi-conducteurs DRAM, ayant au moins une ligne (WL) de mots et une ligne (BL) de bits.
